# EUROPÄISCHE PATENTSCHRIFT

(11) **EP 2 682 738 B1**
(45) Veröffentlichungstag und Bekanntmachung des Hinweises auf die Patenterteilung: **23.12.2020**
(21) Anmeldenummer: 12175185.3
(22) Anmeldetag: 05.07.2012
(51) Int. Cl.: G01N 17/00

(54) **Detektion der Emissionsstrahlung einer UV-Lichtemissionsdiode durch eine baugleiche UV-Lichtempfangsdiode**
Detection of the emission radiation of a UV light emitting diode using a UV light receiving diode of the same design
Détection d'un rayonnement d'émission d'une diode UV luminescente par une diode UV luminescente réceptrice identique

(43) Veröffentlichungstag der Anmeldung: 08.01.2014
(73) Patentinhaber: Atlas Material Testing Technology GmbH, 63589 Linsengericht/Altenhasslau (DE)
(72) Erfinder: Rudolph, Bernd, 63755 Alzenau (DE); March, Peter, 60326 Frankfurt am Main (DE)
(74) Vertreter: Lambsdorff & Lange Patentanwälte Partnerschaft mbB

(56) Entgegenhaltungen:
- DE-B3- 10 350 020
- DE-B3-102004 037 603
- US-A1- 2006 241 726
- US-A1- 2011 079 071

## Beschreibung

Die vorliegende Erfindung betrifft eine UV-Strahlungs- und Empfangsvorrichtung und eine Vorrichtung zur künstlichen Bewitterung oder Lichtechtheitsprüfung von Proben mit einer derartigen UV-Strahlungs- und Empfangsvorrichtung und ein Verfahren zum Betrieb einer Vorrichtung zur künstlichen Bewitterung oder Lichtechtheitsprüfung von Proben.

In Vorrichtungen zur künstlichen Bewitterung wird eine Bewertung des witterungsbedingten Alterungsverhaltens einer Probe, insbesondere einer flächigen Werkstoffprobe, durchgeführt, wobei die Probe einer künstlichen Bewitterung ausgesetzt wird. Derartige Vorrichtungen weisen zu diesem Zweck üblicherweise eine Bewitterungskammer auf, in welcher Halterungsmittel für die Halterung von zu bewitternden Proben und eine Strahlungsquelle zur Beaufschlagung der Proben mit Strahlung, insbesondere mit UV-Strahlung, angeordnet sind.

In derartigen Vorrichtungen zur künstlichen Bewitterung oder Lichtechtheitsprüfung von Werkstoffproben soll zumeist die Lebensdauer von Werkstoffen abgeschätzt werden, die in ihrer Anwendung ständig den natürlichen Wetterverhältnissen ausgesetzt sind und sich somit unter klimatischen Einflüssen wie Sonnenlicht, Sonnenwärme, Feuchtigkeit und dergleichen verschlechtern. Um eine gute Simulation der natürlichen Witterungsgegebenheiten zu erhalten, ist es von Vorteil, wenn die spektrale Energieverteilung des in der Vorrichtung erzeugten Lichtes möglichst derjenigen der natürlichen Sonnenstrahlung entspricht, aus welchem Grund in solchen Geräten als bislang Strahlungsquelle Xenon-Strahler eingesetzt werden. Zusätzlich wird eine zeitraffende Alterungsprüfung der Werkstoffe im Wesentlichen durch eine gegenüber den natürlichen Verhältnissen stark intensivierte Bestrahlung der Proben erzielt, wodurch die Alterung der Proben beschleunigt wird. Somit lässt sich nach verhältnismäßig kurzer Zeit eine Aussage über das Langzeit-Alterungsverhalten einer Werkstoffprobe machen.

Ein Großteil der in künstlichen Bewitterungsgeräten untersuchten Werkstoffproben besteht aus polymeren Werkstoffen. Bei diesen wird die witterungsbedingte Verschlechterung im Wesentlichen durch den UV-Anteil der Sonnenstrahlung hervorgerufen. Die dabei ablaufenden fotochemischen Primärprozesse, also die Absorption von Photonen und die Erzeugung angeregter Zustände oder freier Radikale, sind temperaturunabhängig. Dagegen können die nachfolgenden Reaktionsschritte mit den Polymeren oder Additiven temperaturabhängig sein, so dass die beobachtete Alterung der Werkstoffe ebenfalls temperaturabhängig ist.

In den bisher bekannten Bewitterungsprüfgeräten wird als Strahlungsquelle zumeist eine Xenon-Lampe eingesetzt. Mit dieser kann zwar bekanntermaßen das Sonnenspektrum recht gut simuliert werden, die emittierte Strahlung weist jedoch einen relativ hohen Spektralanteil im infraroten Spektralbereich auf, der zur Vermeidung von zu großer Aufheizung der Proben durch Filter unterdrückt werden muss. Eine handelsübliche Xenon-Strahlungsquelle weist zudem nur eine Lebensdauer von ca. 1500 Stunden auf.

Des Weiteren kann als Strahlungsquelle auch eine Metallhalogenidlampe eingesetzt werden, die jedoch den Nachteil aufweist, dass sie nicht oder nur sehr schwer regelbar ist. Dasselbe gilt auch für Fluoreszenz-Lampen, die ebenfalls bereits als Strahlungsquellen in Bewitterungsprüfgeräten eingesetzt wurden und denen nachteilhaft eine relativ kurze Lebensdauer zukommt. Alle genannten Strahlungsquellen weisen darüber hinaus den Nachteil auf, dass sie spektral nicht veränderbar sind.

Ein weiterer Nachteil der oben genannten konventionellen Strahlungsquellen von Bewitterungsprüfgeräten besteht darin, dass diese entsprechend ihrer Konstruktion und ihrer Ansteuerung relativ unhandlich sind und somit beispielsweise veränderten Bedingungen hinsichtlich der Probenoberflächen der zu bestrahlenden Werkstoffproben nicht angepasst werden können.

Die Druckschrift DE 10 2004 037 603 B3 offenbart eine Bewitterungsvorrichtung mit einer Bewitterungskammer, in welcher zu untersuchende Werkstoffproben künstlichen Bewitterungsbedingungen ausgesetzt werden können. An einer Innenwand der Bewitterungskammer ist zu diesem Zweck eine Mehrzahl von UV-Strahlungsquellen angebracht; als Strahlungsquellen können UV-Lichtemissionsdioden eingesetzt werden. Die Strahlungsleistung jeder dieser UV-Strahlungsquellen wird mit UV-Sensoren gemessen, welche beispielsweise in einer Seitenwand der Bewitterungskammer eingesetzt sein können und für eine Breitbandmessung in dem UV-Bereich von 300 - 400 nm ausgelegt sein können.

Die Druckschrift DE 103 50 020 B3 offenbart eine Bewitterungsvorrichtung mit einer Bewitterungskammer, in welcher Halterungsmittel für die Halterung von zu bewitternden Proben und eine UV-Strahlungsanordnung zur Beaufschlagung der Proben mit UV-Strahlung angeordnet sind, wobei die UV-Strahlungsanordnung eine Anordnung von UV-Lichtemissionsdioden umfasst.

Es ist somit Aufgabe der vorliegenden Erfindung, eine Vorrichtung zur künstlichen Bewitterung oder Lichtechtheitsprüfung so auszugestalten, dass die Emissionsstrahlung einer in der Vorrichtung enthaltenen UV-Lichtemissionsdiode geeignet detektiert werden kann.

Diese Aufgabe wird durch die Merkmale der unabhängigen Patentansprüche gelöst. Vorteilhafte Ausgestaltungen und Weiterbildungen der Erfindung sind in den Unteransprüchen angegeben.

Der vorliegenden Erfindung liegt somit eine wesentliche Erkenntnis zugrunde, wonach eine UV-Lichtempfangsdiode mit größtmöglicher Sensitivität dadurch bereit gestellt werden kann, indem sie baugleich mit der UV-Lichtemissionsdiode ausgeführt wird, deren Emissionsstrahlung sie detektieren soll. Eine solche UV-Lichtempfangsdiode weist somit eine spektrale Absorptionsbande auf, welche im Wesentlichen mit der spektralen Emissionsbande der UV-Lichtemissionsdiode übereinstimmt. Es ist vorgesehen, dass die Maxima der Absorptionsbande der UV-Lichtempfangsdiode und der Emissionsbande der UV-Lichtemissionsdiode bei ein und derselben Wellenlänge oder zumindest relativ nahe beieinander liegen.

Ein wesentlicher Vorteil gegenüber anderen Anordnungen besteht darin, dass mit der UV-Strahlungs- und Empfangsvorrichtung und ihrem Einsatz in einer Vorrichtung zur künstlichen Bewitterung von Proben bereits ein spektral spezifischer Empfänger vorhanden ist. Würde man einen spektral breitbandigen UV-Empfänger verwenden, so müsste für die Messung der Ausgangsleistung von einer von mehreren verschiedenen UV-LEDs ein für die Wellenlänge dieser UV-LED durchlässiges Filter vor dem UV-Empfänger angeordnet werden.

Erfindungsgemäß wird dabei so vorgegangen, dass zwei identische UV-Lichtemissionsdioden oder zumindest zwei nominell oder gemäß Herstellerangaben identische UV-Lichtemissionsdioden bereitgestellt werden und eine davon beim Einbau in eine Probenkammer einer Vorrichtung zur künstlichen Bewitterung oder Lichtechtheitsprüfung als UV-Lichtempfangsdiode eingesetzt und entsprechend elektrisch beschaltet wird. Dabei kann es sich als vorteilhaft erweisen, wenn zwei UV-Lichtemissionsdioden aus ein und derselben herstellerseitigen Charge verwendet werden, um zu gewährleisten, dass beide UV-Lichtemissionsdioden ein und denselben Herstellungsprozess, insbesondere ein und dieselbe Prozessfolge bei der Herstellung der Halbleiter-Schichtstruktur in einer Prozesskammer, durchlaufen haben. Auf diese Weise kann sichergestellt werden, dass die beiden UV-Lichtemissionsdioden möglichst exakt die gleiche Halbleiter-Schichtstruktur aufweisen und somit die von beiden UV-Lichtemissionsdioden später im Betrieb eingesetzte UV-Lichtempfangsdiode hinsichtlich ihres spektralen Absorptionsverhaltens möglichst exakt mit dem spektralen Emissionsverhalten der zu messenden UV-Lichtemissionsdiode übereinstimmt. Für diesen Fall kann dann mit einer maximalen Empfindlichkeit der UV-Lichtempfangsdiode im Betrieb gerechnet werden.

Gemäß einer Ausführungsform der Vorrichtung ist eine UV-Lichtempfangsdiode derart angeordnet, dass im Betrieb der Vorrichtung emittierte Strahlung von mehreren UV-LEDs auf die UV-Empfangsdiode auftrifft, wobei es sich dann vorzugsweise um UV-Lichtemissionsdioden gleicher Ausgangswellenlänge handelt.

Gemäß einer Ausführungsform weist die Vorrichtung eine Mehrzahl von Klassen von UV-LEDs verschiedener Emissionsbanden und eine entsprechende Mehrzahl von UV-Lichtempfangsdioden auf, wobei jede der UV-Lichtempfangsdioden auf derselben Materialbasis hergestellt ist wie eine UV-LED einer Klasse, nämlich einen mit dieser identischen inneren Aufbau oder identische Halbleiter-Schichtstruktur, aufweist. Es kann demnach beispielsweise vorgesehen sein, dass mehrere oder alle UV-LEDs einer Klasse einer bestimmten, baugleichen UV-Lichtempfangsdiode zugeordnet sind, welche die Ausgangsstrahlung dieser UV-LEDs detektieren soll.

Gemäß einer Ausführungsform der Vorrichtung sind die eine oder mehrere UV-LEDs und die UV-Lichtempfangsdiode auf einem gemeinsamen Träger, insbesondere einer Schaltungsplatine, angeordnet.

Gemäß einer Ausführungsform der Vorrichtung sind die eine oder mehrere UV-LEDs auf einem gemeinsamen Träger und die UV-Lichtempfangsdiode auf einem anderen Träger angeordnet. Insbesondere kann vorgesehen sein, dass die zu untersuchenden Proben in einer der UV-Strahlungsvorrichtung gegenüberliegenden Probenebene auf einem dafür geeigneten Träger angeordnet sind und die eine oder mehrere UV-Lichtempfangsdiode ebenfalls auf diesem Träger angeordnet ist.

Gemäß einer Ausführungsform der Vorrichtung sind die eine oder mehrere UV-LEDs und die UV-Lichtempfangsdiode auf die gleiche Weise ausgerichtet. Die UV-LED ist beispielsweise so ausgerichtet, dass sie die UV-Strahlung mit ihrer Hauptstrahlachse in einem rechten Winkel zur Ebene der Platine abstrahlt und die UV-Lichtempfangsdiode kann dann in der gleichen Weise räumlich ausgerichtet auf die Platine montiert sein, sodass sie ebenfalls nur für UV-Strahlung sensitiv ist, die in einer Richtung senkrecht zur Platine auf die UV-Lichtempfangsdiode auftrifft. In diesem Fall ist gegebenenfalls dafür Sorge zu tragen, dass die von der UV-LED emittierte Strahlung in geeigneter Weise der UV-Lichtempfangsdiode zugeführt wird. Dies kann beispielsweise durch ein geeignet geformtes und aus einem geeigneten Material bestehendes Kopplungsmedium geschehen, wie weiter unten anhand eines Ausführungsbeispiels noch näher erläutert werden wird.

Gemäß einer Ausführungsform der Vorrichtung sind die UV-LED und die UV-Lichtempfangsdiode nicht auf die gleiche Weise ausgerichtet, wobei die UV-Lichtempfangsdiode beispielsweise gekippt angeordnet sein kann, wobei sie vorteilhafterweise in Richtung auf die UV-LED gekippt ist. Auf diese Weise kann gegebenenfalls ohne Verwendung eines zusätzlichen Kopplungsmediums die Emissionsstrahlung der UV-LED der UV-Lichtempfangsdiode zugeführt werden. Es kann gleichwohl auch in diesem Fall vorgesehen sein, dass ein derartiges Kopplungsmedium eingesetzt wird.

Gemäß einer Ausführungsform der Vorrichtung ist im Strahlengang des auf die UV-Lichtempfangsdiode auftreffenden Anteils der von der UV-LED emittierten Strahlung ein Kopplungsmedium angeordnet, durch welches dieser Strahlungsanteil auf die UV-Lichtempfangsdiode gelenkt wird. Gemäß einer Aus führungs form kann das Kopplungsmedium eine für UV-Strahlung durchlässige Scheibe wie eine Quarz-Scheibe sein. Gemäß einer Ausführungsform kann das Kopplungsmedium eine für UV-Strahlung durchlässige Glasfaser sein. Gemäß einer Ausführungsform kann auf dem Kopplungsmedium eine für UV-Strahlung undurchlässige Schicht aufgebracht sein, mit der das Eindringen von Streustrahlung in das Kopplungsmedium und das Auftreffen der Streustrahlung auf die UV-Lichtempfangsdiode verhindert werden kann.

Gemäß einer Ausführungsform weist die Vorrichtung mindestens eine weitere UV-LED auf, wobei im Betrieb der Vorrichtung ein Anteil der von der weiteren UV-LED emittierten Strahlung auf die UV-Lichtempfangsdiode auftrifft. Im Falle der Verwendung eines Kopplungsmediums können die weitere UV-LED und das Kopplungsmedium derart relativ zueinander angeordnet sein, dass im Betrieb der Vorrichtung ein Anteil der von der weiteren UV-LED emittierten Strahlung durch das Kopplungsmedium auf die UV-Lichtempfangsdiode gelenkt wird. Es kann beispielsweise vorgesehen sein, dass der Strahlungsanteil der ersten UV-LED an einem lichteintrittsseitigen Ende des Kopplungsmediums in das Kopplungsmedium eingekoppelt wird und der Strahlungsanteil der weiteren UV-LED an einem gegenüberliegenden lichteintrittsseitigen Ende des Kopplungsmediums in das Kopplungsmedium eingekoppelt wird und beide Strahlungsanteile innerhalb des Kopplungsmediums dann auf die UV-Lichtempfangsdiode gelenkt werden. Auch in diesem Fall kann das Kopplungsmedium entweder durch eine Scheibe, insbesondere flache Scheibe, beispielsweise Quarz-Scheibe, oder auch eine Glasfaser gegeben sein.

Gemäß einer Ausführungsform der Vorrichtung ist die UV-Lichtempfangsdiode wahlweise als UV-Lichtempfangsdiode oder als UV-LED betreibbar. Zu diesem Zweck kann die externe elektrische Beschaltung derart ausgeführt sein, dass in einer Schaltkonfiguration für Lichtemission eine Spannung in Durchlassrichtung der Diode anlegbar ist und ein Strom in die Diode injizierbar ist und bei einer Schaltkonfiguration für Lichtempfang eine andere Spannung, gegebenenfalls eine Spannung in Sperrrichtung der Diode, an die Diode anlegbar ist und ein von der Diode aufgrund Lichteinfalls generierter elektrischer Strom detektierbar ist.

Die vorliegende Erfindung bezieht sich ebenso auf ein Verfahren zum Betrieb einer Vorrichtung zur künstlichen Bewitterung oder Lichtechtheitsprüfung von Proben, wobei das Verfahren die folgenden Schritte aufweist:
a. Bereitstellen einer Bewitterungskammer;
b. Bereitstellen von mindestens zwei UV-Halbleiterdioden mit ein und derselben Halbleiter-Schichtstruktur;
c. Anordnen einer ersten der beiden UV-Halbleiterdioden in der Bewitterungskammer und Betreiben der ersten UV-Halbleiterdiode als UV-Lichtemissionsdiode; und
d. Anordnen einer zweiten der beiden UV-Halbleiterdioden in der Bewitterungskammer; und
e. Betreiben der zweiten Halbleiterdiode als UV-Lichtempfangsdiode, wobei die zweite UV-Halbleiterdiode derart relativ zu der ersten UV-Halbleiterdiode angeordnet wird, dass im Betrieb der Vorrichtung ein Anteil der von der ersten UV-Halbleiterdiode emittierten Strahlung auf die zweite UV-Halbleiterdiode auftrifft.

Gemäß einer Ausführungsform des Verfahrens wird im Schritt b. eine Mehrzahl von Klassen von UV-LEDs verschiedener Emissionsbanden und eine Mehrzahl von UV-Lichtempfangsdioden bereitgestellt, wobei jede der UV-Lichtempfangsdioden auf derselben Materialbasis aufgebaut ist wie eine UV-LED einer Klasse, insbesondere einen mit dieser identischen inneren Aufbau oder identische Halbleiter-Schichtstruktur aufweist. Dabei kann insbesondere vorgesehen sein, dass die Mehrzahl von Klassen von UV-LEDs verschiedener Emissionsbanden derart gewählt werden, dass eine Spektralverteilung erzielbar ist, mit der eine bestimmte spektrale UV-Charakteristik approximiert wird. Insbesondere kann mit den UV-LEDs die Anstiegskante des UV-Anteils natürlicher Sonnenstrahlung auf der kurzwelligen Seite approximiert werden. Es kann aber auch eine UV-Emissionsbande einer bekannten UV-Lichtquelle oder eine andere willkürlich definierte UV-Charakteristik approximiert werden.

Gemäß einer Ausführungsform des Verfahrens können im Betrieb die eine oder die mehreren UV-LEDs auf der Basis von Ausgangssignalen der einen oder der mehreren UV-Lichtempfangsdioden geregelt werden. Eine einfache Art der Regelung kann beispielsweise darin bestehen, dass eine von der UV-Lichtempfangsdiode detektierte Abnahme der Strahlungsintensität ausgewertet wird. Es sind aber auch kompliziertere Arten von Regelungen denkbar, bei denen beispielsweise die Strahlungsleistung von jeder von UV-LEDs verschiedener Emissionsbanden derart geregelt wird, dass die Spektralverteilung in der Ebene der zu untersuchenden Proben möglichst räumlich homogen ist oder, anders ausgedrückt, dass eine räumliche Inhomogenität dieser Spektralverteilung auf vorgegebene Abweichungen begrenzt ist. Die gewünschte Spektralverteilung kann wiederum auf Probenebene derart sein, dass der UV-Anteil natürlicher Sonnenstrahlung, insbesondere die im UV-Bereich liegende Anstiegsflanke, oder eine andere gewünschte UV-Charakteristik bestmöglichst approximiert wird.

Im Folgenden wird die Erfindung anhand von Ausführungsbeispielen in Verbindung mit den Zeichnungsfiguren noch näher erläutert. Es zeigen:
Fig. 1 ein Ausführungsbeispiel einer erfindungsgemäßen Vorrichtung zur künstlichen Bewitterung oder Lichtechtheitsprüfung von Proben in einer perspektivischen Ansicht.
Fig. 2 eine Draufsicht auf ein UV-Strahlungsmodul mit einer UV-LED und einer UV-Lichtempfangsdiode.
Fig. 3 eine seitliche Querschnittsansicht einer Anordnung aus einer UV-LED, einer UV-Lichtempfangsdiode und einem zwischen beiden angeordneten Kopplungsmedium.

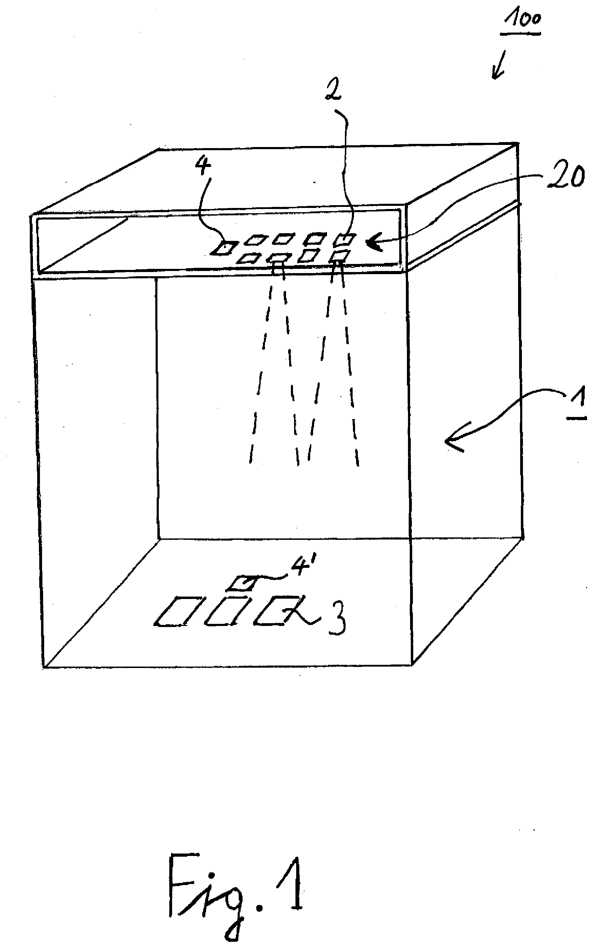

In der Fig. 1 ist eine Ausführungsform für eine Vorrichtung zur künstlichen Bewitterung oder Lichtechtheitsprüfung schematisch perspektivisch dargestellt. Die Vorrichtung weist eine Bewitterungskammer 1 auf, in welcher eine UV-Strahlungsvorrichtung 20 angeordnet ist. Im unteren Bereich der Probenkammer 1 können auf einer Bodenplatte geeignete Halterungsmittel vorhanden sein, mittels derer eine Anzahl Proben 3 gehaltert werden können. Die Vorrichtung kann somit als ein Bewitterungsgerät mit stationärer Probenhalterung ausgelegt sein. Die Erfindung kann jedoch ebenso auf Bewitterungsgeräte mit bewegbaren Probenhalterungen anwendbar sein.

Die UV-Strahlungsvorrichtung 20 kann eine Mehrzahl von UV-LEDs 2 aufweisen, die beispielsweise entlang den Zeilen und Spalten einer Matrix auf einer ebenen Fläche, wie beispielsweise einer Schaltungsplatine, montiert sein können und bezüglich ihrer Abstrahlcharakteristik derart ausgerichtet sein können, dass die Emissionsstrahlung senkrecht nach unten auf die zu untersuchenden Proben 3 gerichtet ist. In einer praktikablen Ausführungsform kann die Schaltungsplatine mit den auf ihrer unteren Oberfläche befestigten UV-LEDs als Teil einer Einschubkassette vorgesehen sein, welche in einen dafür vorgesehenen Schlitz auf der Oberseite der Vorrichtung 100 eingeschoben werden kann. Die Schaltungsplatine bildet dabei eine untere Bodenfläche der Einschubkassette, während der darüber gelegene Raumbereich von einem Kühlmedium durchströmt werden kann, um die von den UV-LEDs erzeugte Wärme effizient abzuführen.

Die Vorrichtung 100 kann selbstredend weitere Elemente enthalten, welche der Bewitterung der Proben 3 dienen und hier lediglich aus Gründen der Einfachheit der Darstellung nicht gezeigt sind.

Die UV-LEDs 2 können auf einer gemeinsamen Schaltungsplatine montiert sein. Ebenfalls auf dieser Schaltungsplatine können eine oder mehrere UV-Lichtempfangsdioden 4 montiert sein, mit welcher jeweils ein Teil der von den UV-LEDs 2 emittierten Strahlung detektiert werden kann. In einem Ausführungsbeispiel weiter unten wird beschrieben, wie die Strahlung der UV-Lichtempfangsdiode 4 zugeführt werden kann. Alternativ oder zusätzlich zu der in der Ebene der UV-LEDs 2 angeordneten UV-Lichtempfangsdiode 4 kann eine UV-Lichtempfangsdiode 4' in derselben Ebene der Proben 3 angeordnet werden. Die UV-Lichtempfangsdioden 4 bzw. 4' sind auf derselben Materialbasis aufgebaut wie die UV-LEDs 2 bzw. eine bestimmte Klasse von UV-LEDs 2 mit einer bestimmten UV-Emissionsbande. Innerhalb der UV-LEDs 2 können eine bestimmte Anzahl verschiedener Klassen entsprechend verschiedener UV-Emissionsbanden vorhanden sein und eine entsprechende Anzahl verschiedener UV-Lichtempfangsdioden 4 bzw. 4' kann vorhanden sein, um die emittierte Strahlung der verschiedenen UV-LEDs 2 der verschiedenen Klassen zu detektieren.

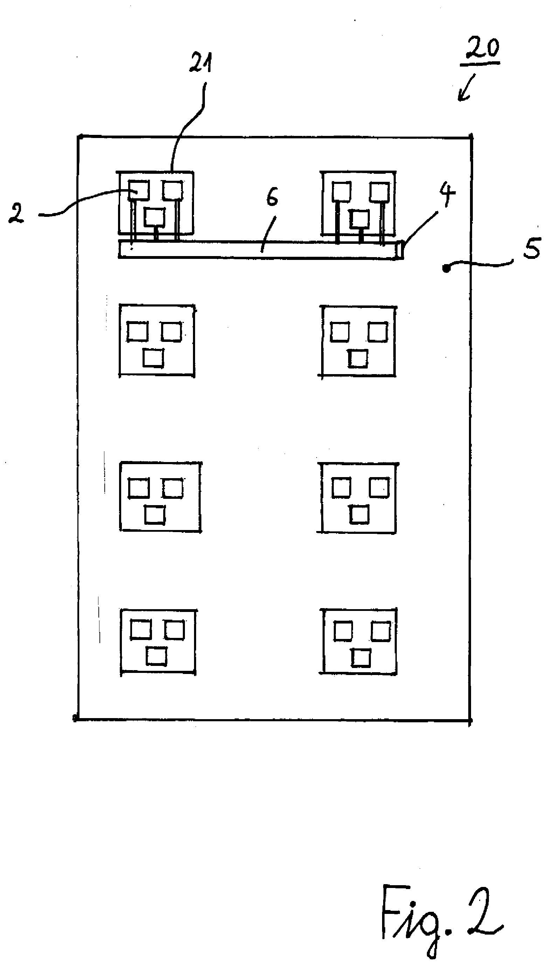

In der Fig. 2 ist eine Draufsicht auf ein UV-Strahlungsmodul oder eine UV-Strahlungsvorrichtung gemäß einer Ausführungsform gezeigt. Das UV-Strahlungsmodul 20 weist in der Regel - wie schon in Fig. 1 gezeigt - eine Mehrzahl von UV-LEDs 2 auf. Die UV-LEDs 2 können auf einem flachen, rechteckförmigen Träger 5 montiert sein, welcher durch eine Schaltungsplatine gegeben sein kann. Das UV-Strahlungsmodul 20 kann - wie in Fig. 1 gezeigt - in einer Vorrichtung 100 zur künstlichen Bewitterung oder Lichtechtheitsprüfung von Proben fixiert sein. Die UV-LEDs 2 sind im Unterschied zu der Anordnung der Fig. 1 nicht räumlich gleich verteilt, sondern in Gruppen 21 zusammengefasst, wobei die Gruppen 21 identisch gebildet sein können. Im dargestellten Ausführungsbeispiel enthalten die Gruppen jeweils drei UV-LEDs 2 verschiedener UV-Emissionsbanden, um mit diesen beispielsweise eine bestimmte gewünschte spektrale UV-Charakteristik wie etwa die UV-Anstiegskante der Sonnenstrahlung zu approximieren. Es können aber in den Gruppen 21 auch beispielsweise jeweils nur zwei UV-LEDs mit verschiedenen Emissionsbanden enthalten sein. Es können aber in jeder der Gruppen auch mehr als drei UV-LEDs verschiedener UV-Emissionsbanden enthalten sein. Gegebenenfalls können in den Gruppen auch UV-LEDs bestimmter Klassen, also bestimmter UV-Emissionsbanden, mehrfach vertreten sein.

Auf der Schaltungsplatine 5 kann unterhalb der oberen Reihe von Gruppen 21 ein Kopplungsmedium wie ein Quarzglasblock 6 montiert sein, in welchen ein Teil der von den UV-LEDs 2 emittierten Strahlung eingekoppelt werden kann. An den Quarzglasblock 6 können an dessen äußerem rechten Ende eine oder mehrere UV-Lichtempfangsdioden 4 montiert sein, auf welche die Strahlung auftrifft. Es können beispielsweise drei verschiedene UV-Lichtempfangsdioden 4 vorhanden sein, von denen jede auf derselben Materialbasis aufgebaut ist wie eine bestimmte UV-LED 2 der beiden Gruppen 21. Die Teilstrahlungsbündel der einzelnen UV-LEDs 21 können durch Glasfaserstücke von den UV-LEDs 21 in den Quarzglasblock 6 eingekoppelt werden. Im Betrieb der Vorrichtung 20 trifft ein Anteil der von einer UV-LED 2 emittierten Strahlung auf eine bestimmte UV-Empfangsdiode 4 auf. Die UV-Empfangsdiode 4 ist von ihrem inneren Schichtaufbau her identisch mit der UV-LED 2, sodass ihre spektrale Absorptionscharakteristik im Wesentlichen der spektralen Emissionscharakteristik der UV-LED 2 entspricht und sie somit für die von der UV-LED 2 emittierte Strahlung eine optimale Sensitivität aufweist. Die UV-Lichtempfangsdiode 4 ist dabei ursprünglich ebenfalls eine UV-LED, die lediglich hinsichtlich ihrer externen elektrischen Beschaltung nunmehr als UV-Lichtempfangsdiode eingesetzt wird. Vorteilhafterweise sind somit die UV-LED 2 und die UV-Lichtempfangsdiode 4 herstellerseitig ursprünglich als UV-LEDs zusammen während ein und desselben Herstellungsprozesses hergestellt worden, insbesondere innerhalb ein und derselben Prozesskammer die Schichten der Halbleiter-Schichtstruktur beider Dioden aufgewachsen worden.

Es kann ferner vorgesehen sein, dass die UV-LEDs 2 innerhalb einer Gruppe derart voneinander beabstandet sind, dass die Abstände vernachlässigbar gegenüber dem Abstand der UV-Strahlungsvorrichtung 20 zur Probenebene ist. Dies hat zur Folge, dass jede Gruppe 21 für sich genommen auf der Probenebene ein in der gewünschten Weise gemischtes ("fertiges") Spektrum erzeugt. Als Abstand der UV-LEDs 2 voneinander kann beispielsweise ein Mittelwert der Mittelpunkts-Abstände von jeweils unmittelbar benachbarten UV-LEDs bestimmt werden und dieser Abstand kann kleiner sein als das 10-fache, 50-fache oder 100-fache des Abstands zwischen der UV-Strahlungsvorrichtung 20 und der Probenebene.

Es ist auch denkbar, dass die externe elektrische Beschaltung der UV-Lichtempfangsdiode 4 derart ausgeführt ist, dass Letztere wahlweise als UV-LED oder UV-Lichtempfangsdiode eingesetzt werden kann.

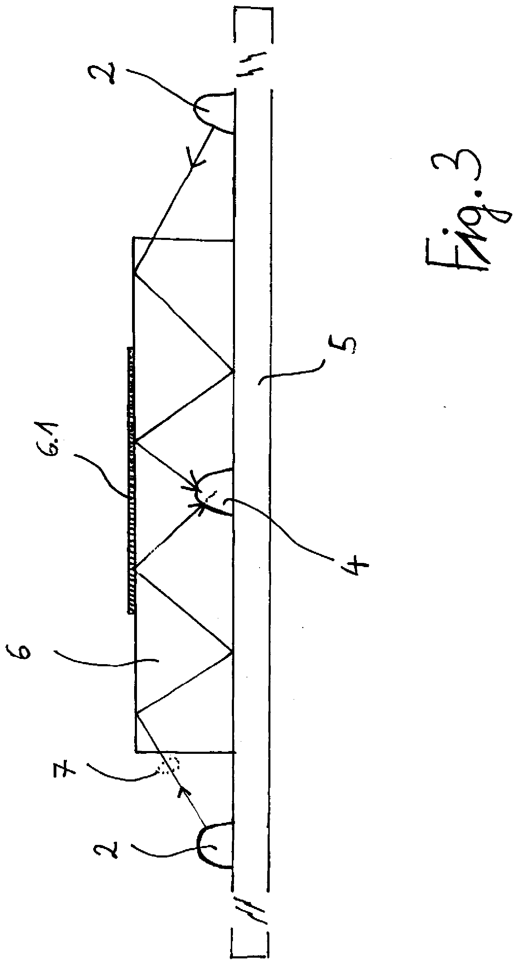

In der Fig. 3 ist eine seitliche Querschnittsansicht einer Anordnung aus zwei UV-LEDs 2, einer UV-Lichtempfangsdiode 4 und einem zwischen beiden angeordneten Kopplungsmedium 6 dargestellt. Die genannten Komponenten können auf einem Träger 5 wie einer Schaltungsplatine montiert sein. Die linksseitige der beiden UV-LEDs 2 ist so ausgerichtet, dass ihre Hauptabstrahlrichtung senkrecht zu der Ebene des Trägers 5 nach oben gerichtet ist und, unter der Annahme eines Lambertschen Strahlers gemäß einer Kosinus-Funktion, mit zunehmendem Winkel zur Abstrahlrichtung die Strahlungsleistung abnimmt. Die unter einem kleinen Winkel zur Ebene des Trägers 5 emittierte Strahlung kann von einem geeigneten, UV-durchlässigen Kopplungsmedium 5 aufgenommen und in Richtung zu der UV-Empfangsdiode 4 weitergeleitet werden. Das Kopplungsmedium 6 kann im gezeigten Ausführungsbeispiel wiederum durch eine Quarz-Platte gebildet sein, welche mit ihrer unteren Oberfläche auf dem Träger 5 direkt oberhalb der UV-Lichtempfangsdiode 4 befestigt sein kann. Die Quarz-Platte 6 kann so ausgeführt sein, dass sie an ihrer unteren Oberfläche eine Einbuchtung aufweist, in der die UV-Lichtempfangsdiode 4 aufgenommen werden kann. An ihrem lichteintrittsseitigen Ende erfasst die Quarz-Platte 6 einen Teil der von der UV-LED 2 emittierten Strahlung in Form eines Strahlungsbündels 7. Von diesem Strahlungsbündel kann wiederum ein Teil im Wege der Totalreflexion an der oberen und unteren Oberfläche der Quarz-Platte 6 in die UV-Lichtempfangsdiode 4 gelangen. Auf der oberen Oberfläche der Quarz-Platte 6 kann eine für UV-Strahlung undurchlässige Schicht 6.1 aufgebracht sein, mit der verhindert wird, dass UV-Streustrahlung in der Probenkammer auf die UV-Lichtempfangsdiode 4 auftrifft.

Es kann des Weiteren vorgesehen sein, dass an einem weiteren lichteintrittsseitigen Ende des Quarz-Platte 6 ein Strahlungsanteil einer weiteren rechtsseitigen UV-LED 2 eingekoppelt und der UV-Lichtempfangsdiode 4 zugeführt wird. Die Quarz-Platte 6 kann auch so ausgeführt sein, dass an weiteren lichteintrittsseitigen Enden Strahlungsanteile von weiteren UV-LEDs 2 eingekoppelt und der UV-Lichtempfangsdiode 4 zugeführt werden.

Anstelle einer Quarz-Platte als Kopplungsmedium 6 kann auch eine UV-durchlässige Glasfaser verwendet werden. Die Glasfaser könnte mit ihrem lichteintrittsseitigen Ende praktisch beliebig nahe an die UV-LED 2 herangeführt werden. Die Glasfaser kann beispielsweise auf einem Teil ihres Umfangs mit einer UV-undurchlässigen Beschichtung versehen werden, um die Einkopplung von UV-Streustrahlung zu verhindern.

Obwohl spezifische Ausführungsformen in dieser Beschreibung dargestellt und beschrieben wurden, ist für den Fachmann auf dem Gebiet zu erkennen, dass die gezeigten und beschriebenen spezifischen Ausführungsformen gegen eine Vielfalt von alternativen und/oder äquivalenten Implementierungen ausgetauscht werden können, ohne vom Schutzbereich der vorliegenden Erfindung abzuweichen. Diese Anmeldung soll jegliche Anpassungen oder Veränderungen der hierin erörterten spezifischen Ausführungsformen abdecken. Daher ist vorgesehen, dass diese Erfindung nur durch die Ansprüche begrenzt ist.

## Patentansprüche

1. UV-Strahlungs- und Empfangsvorrichtung (20), mit mindestens einer UV-Lichtemissionsdiode (UV-LED) (2), und einer UV-Lichtempfangsdiode (4, 4'), welche dieselbe Halbleiter-Schichtstruktur aufweist wie die UV-LED (2) und eine derartige externe elektrische Beschaltung aufweist, dass sie als UV-Lichtempfangsdiode eingesetzt wird und derart relativ zu der UV-LED (2) angeordnet ist, dass im Betrieb der Vorrichtung ein Anteil der von der UV-LED (2) emittierten Strahlung auf die UV-Empfangsdiode (4, 4') auftrifft.

2. UV-Strahlungs- und Empfangsvorrichtung (20) nach Anspruch 1, mit
einer Mehrzahl von Klassen von UV-LEDs (2) verschiedener Emissionsbanden; und
einer entsprechenden Mehrzahl von UV-Lichtempfangsdioden (3), wobei jede der UV-Lichtempfangsdioden (4, 4') auf derselben Materialbasis aufgebaut ist wie eine UV-LED (2) einer Klasse.

3. UV-Strahlungs- und Empfangsvorrichtung (20) nach Anspruch 1 oder 2, bei welcher
die UV-LED (2) und die UV-Lichtempfangsdiode (4) auf einem gemeinsamen Träger (5), insbesondere einer Schaltungsplatine, angeordnet sind.

4. UV-Strahlungs- und Empfangsvorrichtung (20) nach einem der Ansprüche 1 bis 3, bei welcher
die UV-LED (2) und die UV-Lichtempfangsdiode (4) auf die gleiche Weise ausgerichtet sind.

5. UV-Strahlungs- und Empfangsvorrichtung (20) nach einem der Ansprüche 1 bis 3, bei welcher
die UV-LED (2) und die UV-Lichtempfangsdiode (4) nicht auf die gleiche Weise ausgerichtet, insbesondere relativ zueinander gekippt, sind.

6. UV-Strahlungs- und Empfangsvorrichtung (20) nach einem der Ansprüche 1 bis 5, bei welcher
im Strahlengang des auf die Lichtempfangsdiode (4) auftreffenden Anteils ein Kopplungsmedium (6) angeordnet ist, durch welches der Anteil auf die UV-Lichtempfangsdiode (4) gelenkt wird.

7. UV-Strahlungs- und Empfangsvorrichtung (20) nach Anspruch 6, bei welcher
das Kopplungsmedium (6) eine für UV-Strahlung durchlässige Scheibe ist.

8. UV-Strahlungs- und Empfangsvorrichtung (20) nach einem der Ansprüche 1 bis 7, welche
mindestens eine weitere UV-LED (2) aufweist, wobei im Betrieb der Vorrichtung ein Anteil der von der weiteren UV-LED emittierten Strahlung auf die UV-Lichtempfangsdiode (4) auftrifft.

9. UV-Strahlungs- und Empfangsvorrichtung (20) nach Anspruch 8 und einem der Ansprüche 6 oder 7, bei welcher
die weitere UV-LED (2) und das Kopplungsmedium (6) derart relativ zueinander angeordnet sind, dass im Betrieb der Vorrichtung ein Anteil der von der weiteren UV-LED (2) emittierten Strahlung durch das Kopplungsmedium (6) auf die UV-Lichtempfangsdiode (4) gelenkt wird.

10. Vorrichtung zur künstlichen Bewitterung oder Lichtechtheitsprüfung von Proben, mit
einer Bewitterungskammer (1); und
einer in der Bewitterungskammer (1) angeordneten UV-Strahlungs- und Empfangsvorrichtung (20) nach einem der Ansprüche 1 bis 9.

11. Verfahren zum Betrieb einer Vorrichtung zur künstlichen Bewitterung oder Lichtechtheitsprüfung von Proben, mit den Schritten:
a. Bereitstellen einer Bewitterungskammer (1);
b. Bereitstellen von mindestens zwei UV-Halbleiterdioden (2, 4, 4') mit ein und derselben Halbleiter-Schichtstruktur;
c. Anordnen einer ersten (2) der beiden UV-Halbleiterdioden (2, 4) in der Bewitterungskammer (1) und Betreiben der ersten UV-Halbleiterdiode (2) als UV-Lichtemissionsdiode; und
d. Anordnen einer zweiten (4, 4') der beiden UV-Halbleiterdioden (2, 4) in der Bewitterungskammer (1); und
e. Betreiben der zweiten Halbleiterdiode (4, 4') als UV-Lichtempfangsdiode, wobei die zweite UV-Halbleiterdiode (4, 4') derart relativ zu der ersten UV-Halbleiterdiode (2) angeordnet wird, dass im Betrieb der Vorrichtung ein Anteil der von der ersten UV-Halbleiterdiode (2) emittierten Strahlung auf die zweite UV-Halbleiterdiode (4, 4') auftrifft.

12. Verfahren nach Anspruch 11, bei welchem
im Schritt b. eine Mehrzahl von Klassen von UV-LEDs verschiedener Emissionsbanden und eine Mehrzahl von UV-Lichtempfangsdioden bereitgestellt werden, wobei
jede der UV-Lichtempfangsdioden auf derselben Materialbasis aufgebaut ist wie eine UV-LED einer Klasse.

13. Verfahren nach Anspruch 12, bei welchem
im Schritt b. die Mehrzahl von Klassen von UV-LEDs verschiedener Emissionsbanden derart gewählt wird, dass eine bestimmte spektrale UV-Charakteristik approximiert wird.

14. Verfahren nach einem der Ansprüche 11 bis 13, mit dem weiteren Schritt:
f. Regeln des Betriebs der UV-Lichtemissionsdiode (2) auf der Basis eines Ausgangssignals der UV-Lichtempfangsdiode (4).

15. Verfahren nach Anspruch 13, mit dem weiteren Schritt:
f. Regeln des Betriebs der UV-Lichtemissionsdioden auf der Basis von Ausgangssignalen der UV-Lichtempfangsdioden.

## Claims

1. UV radiation and receiving device (20), with
at least one UV light-emitting diode (UV LED) (2), and
a UV light-receiving diode (4, 4') which has the same semi-conductor layer structure as the UV LED (2) and has an external electrical circuitry such that it is used as a UV light-receiving diode and is arranged relative to the UV LED (2) in such a way that during operation of the device a proportion of the radiation emitted by the UV LED (2) impinges on the UV receiving diode (4, 4').

2. UV radiation and receiving device (20) according to claim 1, with
a plurality of classes of UV LEDs (2) of different emission bands; and
a corresponding plurality of UV light-receiving diodes (3), each of said UV light-receiving diodes (4, 4') being constructed on the same material base as a UV LED (2) of one class.

3. UV radiation and receiving device (20) according to claim 1 or 2, wherein
the UV LED (2) and the UV light-receiving diode (4) are arranged on a common carrier (5), in particular a circuit board.

4. UV radiation and receiving device (20) according to one of claims 1 to 3, in which
the UV LED (2) and the UV light receiving diode (4) are aligned in the same way.

5. UV radiation and receiving device (20) according to one of claims 1 to 3, in which
the UV LED (2) and the UV light-receiving diode (4) are not aligned in the same way, in particular they are tilted relative to each other.

6. UV radiation and receiving device (20) according to any one of claims 1 to 5, in which
a coupling medium (6) is arranged in the beam path of the proportion of the radiation impinging on the light-receiving diode (4), through which the proportion is directed onto the UV light-receiving diode (4).

7. UV radiation and receiving device (20) according to claim 6, in which
the coupling medium (6) is a pane that is transparent to UV radiation.

8. UV radiation and receiving device (20) according to one of claims 1 to 7, which
has at least one further UV LED (2), whereby when the device is in operation a proportion of the radiation emitted by the further UV LED impinges on the UV light-receiving diode (4).

9. UV radiation and receiving device (20) according to claim 8 and one of the claims 6 or 7, in which
the further UV LED (2) and the coupling medium (6) are arranged relative to one another in such a way that, during operation of the device, a proportion of the radiation emitted by the further UV LED (2) is directed through the coupling medium (6) onto the UV light-receiving diode (4).

10. Device for artificial weathering or lightfastness testing of samples, with
a weathering chamber (1); and
a UV radiation and receiving device (20) according to one of claims 1 to 9 arranged in the weathering chamber (1).

11. Method for operating a device for artificial weathering or lightfastness testing of samples, comprising the steps
a. Providing a weathering chamber (1);
b. Providing at least two UV semiconductor diodes (2, 4, 4') with one and the same semiconductor layer structure;
c. Arranging a first (2) of the two UV-semiconductor diodes (2, 4) in the weathering chamber (1) and operating the first UV-semiconductor diode (2) as a UV light emitting diode; and
d. Arranging a second (4, 4') of the two UV semiconductor diodes (2, 4) in the weathering chamber (1); and
e. Operating the second semiconductor diode (4, 4') as a UV light receiving diode, the second UV semiconductor diode (4, 4') being arranged relative to the first UV semiconductor diode (2) in such a way that during operation of the device a proportion of the radiation emitted by the first UV semiconductor diode (2) impinges on the second UV semiconductor diode (4, 4').

12. Method according to claim 11, in which
in step b. a plurality of classes of UV LEDs of different emission bands and a plurality of UV light receiving diodes are provided, wherein
each of the UV light-receiving diodes is constructed on the same material basis as a UV LED of one class.

13. Method according to claim 12, wherein
in step b. the majority of classes of UV LEDs of different emission bands are selected in such a way that a certain spectral UV characteristic is approximated.

14. Method according to one of claims 11 to 13, with the further step
f. Controlling the operation of the UV light emission diode (2) on the basis of an output signal of the UV light receiving diode (4) .

15. Method according to claim 13, with the further step:
f. Controlling the operation of the UV light-emitting diodes on the basis of output signals of the UV light-receiving diodes.

## Revendications

1. Dispositif de réception et de rayonnement UV (20), avec au moins une diode électroluminescente UV (DEL UV) (2), et une diode réceptrice de lumière UV (4, 4') qui présente la même structure de couches semi-conductrices que la DEL UV (2) et qui est dotée d'un circuit électrique externe tel qu'elle est utilisée comme diode réceptrice de lumière UV et qui est disposée par rapport à la DEL UV (2) de telle manière que, pendant le fonctionnement du dispositif, une partie du rayonnement émis par la DEL UV (2) frappe la diode réceptrice UV (4, 4').

2. Dispositif de réception et de rayonnement UV (20) selon la revendication 1, avec
une pluralité de classes de LED UV (2) de différentes bandes d'émission; et
une pluralité correspondante de diodes réceptrices de lumière UV (3), chacune desdites diodes réceptrices de lumière UV (4, 4') étant construite sur la même base de matériau qu'une LED UV (2) d'une classe.

3. Dispositif de réception et de rayonnement UV (20) selon la revendication 1 ou 2, dans lequel
la LED UV (2) et la diode réceptrice de lumière UV (4) sont disposées sur un support commun (5), en particulier une carte de circuit imprimé.

4. Dispositif de réception et de rayonnement UV (20) selon l'une des revendications 1 à 3, dans lequel
la LED UV (2) et la diode réceptrice de lumière UV (4) sont alignées de la même manière.

5. Dispositif de réception et de rayonnement UV (20) selon l'une quelconque des revendications 1 à 3, dans lequel
la DEL UV (2) et la diode réceptrice de lumière UV (4) ne sont pas alignées de la même manière, surtout si elles sont inclinées l'une par rapport à l'autre.

6. Dispositif de réception et de rayonnement UV (20) selon l'une des revendications 1 à 5, dans lequel
un milieu de couplage (6) est disposé dans le trajet du faisceau de la partie qui frappe la diode réceptrice de lumière (4), au moyen duquel la partie est dirigée sur la diode réceptrice de lumière UV (4).

7. Dispositif de réception et de rayonnement UV (20) selon la revendication 6, dans lequel
le support de couplage (6) est un disque transparent au rayonnement UV.

8. Dispositif de réception et de rayonnement UV (20) selon l'une des revendications 1 à 7, qui
comporte au moins une autre LED UV (2), une partie du rayonnement émis par l'autre LED UV étant dirigée vers la diode réceptrice de lumière UV (4) pendant le fonctionnement de l'appareil.

9. Dispositif de réception et de rayonnement UV (20) selon la revendication 8 et l'une des revendications 6 ou 7, dans lequel l'autre LED UV (2) et le milieu de couplage (6) sont disposés l'un par rapport à l'autre de telle sorte que, pendant le fonctionnement de l'appareil, une partie du rayonnement émis par l'autre LED UV (2) est dirigée à travers le milieu de couplage (6) sur la diode réceptrice de lumière UV (4).

10. Dispositif permettant de tester la résistance des échantillons aux intempéries ou à la lumière artificielle, avec une chambre d'altération (1); et
un dispositif de réception et de rayonnement UV (20) selon l'une des revendications 1 à 9 disposé dans la chambre de vieillissement (1) .

11. Méthode de fonctionnement d'un dispositif pour tester la résistance aux intempéries ou à la lumière artificielle d'échantillons, comprenant les étapes suivantes
a. Fournir une chambre d'altération (1);
b. Fournir au moins deux diodes UV à semi-conducteurs (2, 4, 4') avec une seule et même structure de couche semi-conductrice ;
c. en plaçant une première (2) des deux diodes UV à se- mi-conducteurs (2, 4) dans la chambre de vieillissement (1) et en faisant fonctionner la première diode UV à semi-conducteurs (2) comme une diode d'émission de lumière UV ; et
d. en plaçant une deuxième (4, 4') des deux diodes UV à se- mi-conducteurs (2, 4) dans la chambre de vieillissement (1) ; et
e. faire fonctionner la deuxième diode à semi-conducteur (4, 4') comme une diode réceptrice de lumière UV, la deuxième diode à semi-conducteur UV (4, 4') étant disposée par rapport à la première diode à semi-conducteur UV (2) de telle sorte que, pendant le fonctionnement du dispositif, une partie du rayonnement émis par la première diode à semi-conducteur UV (2) frappe la deuxième diode à semi-conducteur UV (4, 4').

12. Méthode selon la revendication 11, dans laquelle
à l'étape b. une pluralité de classes de DEL UV de différentes bandes d'émission et une pluralité de diodes réceptrices de lumière UV sont prévues, dans lesquelles
chacune des diodes réceptrices de lumière UV est construite sur la même base matérielle qu'une LED UV d'une classe.

13. Méthode selon la revendication 12, dans laquelle
à l'étape b., la majorité des classes de DEL UV de différentes bandes d'émission sont sélectionnées de manière à obtenir une certaine caractéristique UV spectrale approximative.

14. Méthode selon l'une des revendications 11 à 13, avec l'étape suivante :
f. contrôler le fonctionnement de la diode émettrice de lumière UV (2) sur la base d'un signal de sortie de la diode réceptrice de lumière UV (4).

15. Méthode selon la revendication 13, avec l'étape suivante :
f. Contrôler le fonctionnement des diodes électroluminescentes UV sur la base des signaux de sortie des diodes réceptrices de lumière UV.
